# EUROPÄISCHE PATENTANMELDUNG

(11) **EP 1 657 556 A1**
(43) Veröffentlichungstag der Anmeldung: **17.05.2006**
(21) Anmeldenummer: 04030223.4
(22) Anmeldetag: 21.12.2004
(51) Int. Cl.: G01R 19/155, G01R 19/165, G01R 19/25, G01R 31/04

(54) **Spannungs- und Phasenprüfer**

(30) Priorität: 11.11.2004 DE 102004054452
(71) Anmelder: ABB PATENT GmbH, 68526 Ladenburg (DE)
(72) Erfinder: Ewers, Manfred, Dipl.-Ing.,Dipl.Wirt.-Ing., 58239 Schwerte (DE); Sahlmann, Hans-Peter, 58454 Witten (DE)
(74) Vertreter: Miller, Toivo

(57) **Zusammenfassung**

Es wird ein Spannungs- und Phasenprüfer (1) mit einem stabförmigen Gehäuse (2, 3) aus einem elektrisch isolierenden Material vorgeschlagen, an dessen unterer Stirnseite zwei zum Eingriff in die Pole einer Steckdose geeignete Steckerstifte (4, 5) angeordnet sind, welche gehäuseintern mit dem Eingang eines Analog/Digital-Wandlers (10) verbunden sind, der ausgangsseitig den aktuell detektierten Spannungswert einer im Gehäuse integrierten Digitalanzeige (6) zuführt.

## Beschreibung

Die Erfindung bezieht sich auf einen zur Überprüfung von Steckdosen verwendbaren Spannungs- und Phasenprüfer.

Aus der DE 198 26 717 C2 ist ein Spannungsprüfer bekannt, bestehend aus einem einen stabförmigen Metallschaft (Klinge) ummantelnden Handgriff, der in seinem Inneren in einer Kassette eine Reihenschaltung einer Glimmlampe und eines Widerstandes aufnimmt, welche einerseits mit der Klinge und andererseits mit einem von der Hand eines Benutzers zu berührenden Kontakt elektrisch verbunden ist.

Aus der DE 198 16 542 A1 ist ein Phasenprüfer bekannt, der an Stelle einer Glimmlampen-Widerstands-Reihenschaltung einen ASIC-Baustein mit LCD-Digitalanzeige aufweist.

Ferner sind Spannungsprüfer mit zwei Prüfgriffen mit Prüfelektroden bekannt, welche über eine flexible Leitung miteinander verbunden sind, siehe hierzu beispielsweise DE 31 25 552 C1.

Diese bekannten Spannungs- und Phasenprüfer sind bei Steckdosen mit erhöhtem Berührungsschutz nicht anwendbar, da es bei derartigen Steckdosen zwingend erforderlich ist, zwei Steckerstifte gleichzeitig in die beiden Pole einer Steckdose einzuführen.

Wird nur ein Prüfstift in einen Pol eingeführt, blockiert der Berührungsschutz, wodurch ein Zugang zu den elektrischen Kontakten der Steckdose unterbunden wird. Auch bei nicht exakt synchronem Einführen von zwei Prüfelektroden erfolgt eine derartige Aktivierung des Berührungsschutzes.

Der Erfindung liegt die Aufgabe zugrunde, einen Spannungs- und Phasenprüfer für den Handgebrauch anzugeben, welcher problemlos auch bei Steckdosen mit erhöhtem Berührungsschutz eingesetzt werden kann.

Diese Aufgabe wird erfindungsgemäß gelöst durch einen Spannungs- und Phasenprüfer mit einem vorzugsweise stabförmigen Gehäuse aus einem elektrisch isolierenden Material, an dessen unterer Stirnseite zwei zum Eingriff in die Pole einer Steckdose geeignete Steckerstifte angeordnet sind, welche gehäuseintern mit dem Eingang eines Analog/Digital-Wandlers verbunden sind, der ausgangsseitig den aktuell detektierten Spannungswert einer im Gehäuse integrierten Digitalanzeige zuführt.

Diese Aufgabe wird alternativ gelöst durch einen Spannungs- und Phasenprüfer mit einem vorzugsweise stabförmigen Gehäuse aus einem elektrisch isolierenden Material, an dessen unterer Stirnseite zwei zum Eingriff in die Pole einer Steckdose geeignete Steckerstifte angeordnet sind, welche gehäuseintern mit einer Serienschaltung mindestens eines Vorwiderstandes und mindestens einer Anzeigeleuchte verbunden sind, welche bei Detektion einer Spannung aufleuchtet.

Die mit der Erfindung erzielbaren Vorteile bestehen insbesondere darin, dass der Spannungs- und Phasenprüfer optimal für Steckdosen mit erhöhtem Berührungsschutz geeignet ist, ohne jedoch darauf beschränkt zu sein. Eine Batterie ist für die Funktionsweise des Spannungs- und Phasenprüfers entbehrlich, da der für die elektrischen Baukomponenten benötigte Strom aus dem über die Pole der Steckdose geleiteten Prüfstrom gewonnen wird.

Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Fig.1: eine Sicht auf die Vorderseite eines Spannungs- und Phasenprüfers,
- Fig. 2: eine Seitenansicht eines Spannungs- und Phasenprüfers,
- Fig. 3: eine perspektivische Ansicht eines Spannungs- und Phasenprüfers,
- Fig. 4: eine schematische Darstellung der elektrischen Verschaltung,
- Fig. 5: eine erste alternative Ausführungsform eines Spannungs- und Phasenprüfers,
- Fig. 6: eine zweite alternative Ausführungsform eines Spannungs- und Phasenprüfers.

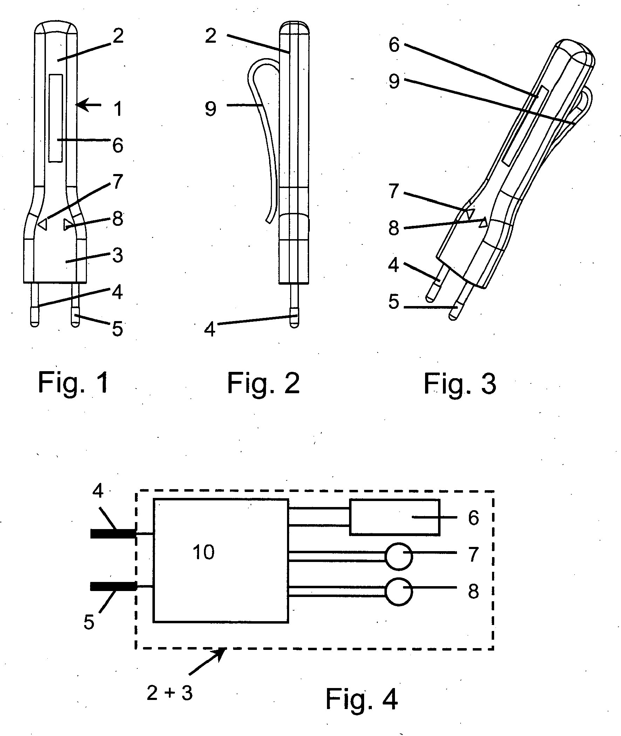

In Fig. 1 ist eine Sicht auf die Vorderseite eines Spannungs- und Phasenprüfers (Breitseite) dargestellt. Der Spannungs- und Phasenprüfer 1 weist ein vorzugsweise stabförmiges Gehäuse aus elektrisch isolierendem Kunststoffmaterial auf und besteht aus einem schmalem Gehäuse-Oberteil 2 und einem hierzu verbreitertem, einem handelsüblichen Stecker nachgebildeten Gehäuse-Unterteil 3. An der Stirnfläche des Gehäuse-Unterteils 3 sind zwei Steckerstifte 4, 5 als Prüfelektroden angeordnet. Die Abmessungen dieses Gehäuse-Unterteils 3 inklusive Anordnung / Dimensionierung der Steckerstifte 4, 5 entsprechen exakt den Abmessungen eines allgemein bekannten EURO-Steckers oder SCHUKO-Steckers, so dass ein Einführen des Spannungs- und Phasenprüfers in eine Steckdose mit erhöhtem Berührungsschutz problemlos ermöglicht wird, ohne dass dabei der Berührungsschutz aktiviert wird.

Bei einer Ausführungsform mit EURO-Stecker ist der Spannungs- und Phasenprüfer vorteilhaft universal für sämtliche Steckdosen anwendbar, in denen auch der EURO-Stecker passt, wie beispielsweise Steckdosen mit Mittelerde, Stifterde, ohne Erde, EU-RO-Amerikanische Steckdosen usw.

lm Gehäuse-Oberteil 2 ist eine Digitalanzeige 6, vorzugsweise LCD-Digitalanzeige, zur Anzeige eines gemessenen Spannungswerts angeordnet. lm oberen Bereich des Gehäuse-Unterteils 3 befinden sich vorzugsweise in räumlicher Zuordnung zu den Steckerstiften 4 bzw. 5 zwei Leuchtdioden 7 bzw. 8, die bei eingestecktem Spannungs- und Phasenprüfer 1 anzeigen, welcher Steckerstift 4 bzw. 5 elektrischen Kontakt mit dem Phasenleiter der Steckdose hat.

In Fig. 2 ist eine Seitenansicht eines Spannungs- und Phasenprüfers (Schmalseite) dargestellt. Wie zu erkennen, ist am Gehäuse-Oberteil 2 ein Klipp 9 befestigt, welcher es einem Handwerker ermöglicht, den Spannungs- und Phasenprüfer 1 wie einen Kugelschreiber an einer Hemdtasche zu befestigen und mitzuführen.

In Fig. 3 ist eine perspektivische Ansicht eines Spannungs- und Phasenprüfers dargestellt. Es sind die beiden Steckerstifte 4, 5, die beiden oberhalb dieser Steckerstifte angeordneten Leuchtdioden 7, 8, die Digitalanzeige 6 und der Klipp 9 zu erkennen.

In Fig. 4 ist eine schematische Darstellung der elektrischen Verschaltung des Spannungs- und Phasenprüfers 1 dargestellt. Als zentrale elektronische Baukomponente dient ein Analog/Digital-Wandler 10, der eingangsseitig über die beiden Steckerstifte 4, 5 elektrischen Kontakt mit den beiden Polen (Phasenleiter, Neutralleiter) einer Steckdose hat. Der Analog/Digital-Wandler 10 bereitet die erfasste Spannung auf und beaufschlagt die Digitalanzeige 6 dementsprechend, um den aktuell erfassten Spannungswert zur Anzeige zu bringen. Des weiteren beaufschlagt der Analog/Digital-Wandler 10 eine der beiden Leuchtdiode 7 oder 8 in Abhängigkeit davon, welcher Steckerstift 4 oder 5 Kontakt mit dem Phasenleiter hat. Die Energie zum Betrieb der elektrischen / elektronischen Komponenten des Spannungs-und Phasenprüfers 1 wird dem Prüfstrom entnommen.

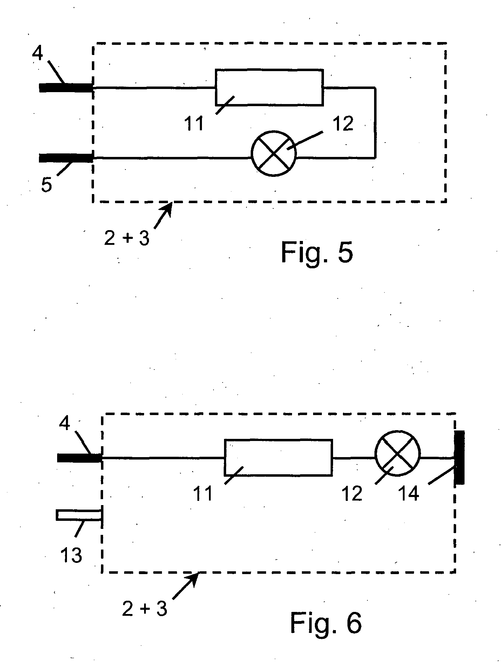

In Fig. 5 ist eine erste alternative Ausführungsform eines Spannungs- und Phasenprüfers dargestellt. Bei dieser vereinfachten und preiswerten Ausführungsform ist im Gehäuse 2 + 3 lediglich die Serienschaltung eines mit Steckerstift 4 verbundenen Vorwiderstandes 11 und einer mit Steckerstift 5 verbundenen Anzeigeleuchte 12 eingebaut, wobei die Anzeigeleuchte 12 beispielsweise als Glimmlampe oder als Leuchtdiode ausgebildet ist und bei Anliegen einer Spannung zwischen den Steckerstiften 4, 5 aufleuchtet. Wahlweise können auch bei dieser Ausführungsform zwei Leuchtdioden vorgesehen sein, welche anzeigen, welcher der beiden Steckerstifte (4, 5) den Phasenleiter elektrisch kontaktiert. Ferner kann auch eine an eine Spannungsteilerschaltung angeschlossene Leuchtdioden-Kette (mehrere Leuchtdioden, welche in einer Reihe angeordnet sind) vorgesehen sein, um anhand der leuchtenden Leuchtdioden anzuzeigen, wie hoch die zwischen den Steckerstiften 4, 5 anliegende Spannung ist.

Bei den Ausführungsformen gemäß Fig. 4 und 5 ist es vorteilhaft nicht erforderlich, dass der Benutzer irgend einen metallischen Kontakt des Spannungs- und Phasenprüfers berührt, um zu detektieren, ob (und an welchem Pol) die zu prüfende Steckdose elektrische Spannung führt oder nicht.

In Fig. 6 ist eine zweite alternative Ausführungsform eines Spannungs- und Phasenprüfers dargestellt. Diese Ausführungsform ist für Anwendungen einsetzbar, bei denen lediglich die Phasenseite ermittelt werden soll. Lediglich einer der beiden Steckerstifte wird als elektrischer Anschluss benötigt, so dass der weitere Steckerstift auch in Form eines Steckerstiftes 13 aus lsoliermaterial ausführbar ist. Bei dieser Variante ist es erforderlich, dass der Benutzer einen an der Außenseite des Gehäuses zugänglichen Metallkontakt 14 des Spannungs- und Phasenprüfers berührt, um zu detektieren, ob Steckerstift 4 die Phase der zu prüfenden Steckdose kontaktiert oder nicht. Demgemäss ist innerhalb des Gehäuses 2 + 3 eine Serienschaltung vom Steckerstift 4 über den Vorwiderstand 11 und die Anzeigeleuchte 12 zum Metallkontakt 14 vorgesehen.

Es ist selbstverständlich, dass außer dem vorstehend erwähnten stabförmigem Gehäuse auch andere Gehäuseformen verwendbar sind, welche ergonomisch sinnvoll sind.

### Bezugszeichenliste:

- 1: Spannungs- und Phasenprüfer
- 2: Gehäuse-Oberteil
- 3: Gehäuse-Unterteil
- 4: Steckerstift
- 5: Steckerstift
- 6: Digitalanzeige
- 7: Leuchtdiode
- 8: Leuchtdiode
- 9: Klipp
- 10: Analog/Digital-Wandler
- 11: Vorwiderstand
- 12: Anzeigeleuchte (Glimmlampe oder Leuchtdiode)
- 13: Steckerstift aus Isoliermaterial
- 14: Metallkontakt

## Patentansprüche

1. Spannungs- und Phasenprüfer (1) mit einem vorzugsweise stabförmigen Gehäuse (2, 3) aus einem elektrisch isolierenden Material, an dessen unterer Stirnseite zwei zum Eingriff in die Pole einer Steckdose geeignete Steckerstifte (4, 5) angeordnet sind, welche gehäuseintern mit dem Eingang eines Analog/Digital-Wandlers (10) verbunden sind, der ausgangsseitig den aktuell detektierten Spannungswert einer im Gehäuse integrierten Digitalanzeige (6) zuführt.

2. Spannungs- und Phasenprüfer (1) mit einem vorzugsweise stabförmigen Gehäuse (2, 3) aus einem elektrisch isolierenden Material, an dessen unterer Stirnseite zwei zum Eingriff in die Pole einer Steckdose geeignete Steckerstifte (4, 5) angeordnet sind, wobei mindestens ein Steckerstift (4) gehäuseintern mit einer Serienschaltung mindestens eines Vorwiderstandes (11) und mindestens einer Anzeigeleuchte (12) verbunden ist, welche bei Detektion einer Spannung aufleuchtet.

3. Spannungs- und Phasenprüfer (1) nach Anspruch 2, **dadurch gekennzeichnet, dass** die Serienschaltung zwischen beiden Steckerstiften (4, 5) geschaltet ist.

4. Spannungs- und Phasenprüfer (1) nach Anspruch 2, **dadurch gekennzeichnet, dass** die Serienschaltung zwischen einem Steckerstift (4) und einem an der Außenseite des Gehäuses zugänglichen, vom Benutzer zu berührenden Metallkontakt (14) geschaltet ist.

5. Spannungs- und Phasenprüfer (1) nach Anspruch 4, **dadurch gekennzeichnet, dass** der elektrisch nicht beschaltete Streckerstift (13) aus Isoliermaterial gebildet ist.

6. Spannungs- und Phasenprüfer nach Anspruch 1 oder 2, **dadurch gekennzeichnet, dass** mit Hilfe von zwei Leuchtdioden (7, 8) zusätzlich angezeigt wird, welcher der beiden Steckerstifte (4, 5) den Phasenleiter elektrisch kontaktiert.

7. Spannungs- und Phasenprüfer nach Anspruch 6, **dadurch gekennzeichnet, dass** die beiden Leuchtdioden (7, 8) den Steckerstiften (4, 5) räumlich zugeordnet sind.

8. Spannungs- und Phasenprüfer nach Anspruch 2, **gekennzeichnet durch** Einsatz einer Glimmlampe als Anzeigeleuchte (12).

9. Spannungs- und Phasenprüfer nach Anspruch 2, **gekennzeichnet durch** Einsatz mindestens einer Leuchtdiode als Anzeigeleuchte (12).

10. Spannungs- und Phasenprüfer nach Anspruch 9, **dadurch gekennzeichnet, dass** mehrere an eine Spannungsteilerschaltung angeschlossene Leuchtdioden vorgesehen sein, um anzuzeigen, wie hoch die zwischen den Steckerstiften (4, 5) anliegende Spannung ist.

11. Spannungs- und Phasenprüfer nach einem der vorstehenden Ansprüche, **dadurch gekennzeichnet, dass** die unterer Stirnseite des Gehäuses mit den zwei zum Eingriff in die Pole einer Steckdose geeigneten Steckerstiften (4, 5) in Form eines EU-RO-Steckers ausgebildet ist.

12. Spannungs- und Phasenprüfer nach einem der Ansprüche 1 - 10, **dadurch gekennzeichnet, dass** die untere Stirnseite des Gehäuses mit den zwei zum Eingriff in die Pole einer Steckdose geeigneten Steckerstiften (4, 5) in Form eines SCHUKO-Steckers ausgebildet ist.
